# EUROPEAN PATENT APPLICATION

(11) **EP 4 769 453 A1**
(43) Date of publication of application: **01.07.2026**
(21) Application number: 25196930.9
(22) Date of filing: 20.08.2025
(51) Int. Cl.: H01C 7/02, H01C 1/084, H01C 7/00, H01C 7/04, H01C 1/14, H01C 7/10, H01C 1/142, H01C 7/13, H02H 9/02, H01H 85/046, H01C 1/014

(54) **CIRCUIT PROTECTION DEVICE**

(30) Priority: 31.12.2024 KR 20240201906
(71) Applicant: Smart Electronics Inc., Ulju-gun, Ulsan 44956 (KR)
(72) Inventor: KANG, Doo Won, 44629 Ulsan (KR); SHIN, A Lam, 46963 Busan (KR)
(74) Representative: Pereira da Cruz, Joao

(57) **Abstract**

Provided is a circuit protection device including: a plate-shaped thermistor element comprising a first electrode and a second electrode; a first heat-dissipating terminal connected to the first electrode; a second heat-dissipating terminal connected to the second electrode; and a housing protecting the thermistor element, the first heat-dissipating terminal and the second heat-dissipating terminal. According to the present disclosure, the circuit protection device having a surface mount device (SMD) structure may be applied to a slim wall-mounted television.

## Description

### CROSS-REFERENCE TO RELATED APPLICATION

This application claims priority to and the benefit of Korean Patent Application No. 10-2024-0201906 filed on December 31, 2024, the disclosure of which is incorporated herein by reference in its entirety.

### BACKGROUND

### Technical Field

The present disclosure relates to a circuit protection device, and more particularly, to a circuit protection device that limits inrush current during the initial operation of an electronic device and prevents a fire caused by internal temperature rise or overcurrent.

### Description of Related Technology

The material presented in this section merely provides background information for the present disclosure and does not constitute related art.

In general, large electronic appliances such as televisions, air conditioners, washing machines, refrigerators, and dryers include circuit protection devices at the power input terminals of electrical circuits of large electronic appliances to prevent equipment failure caused by excessive pulse values, such as inrush current and surge voltage, that occur when power is applied.

Inrush current refers to a high pulse current that temporarily occurs in an electrical circuit when the power of an electronic device is turned on. Large inrush currents may exceed the current limits of semiconductor devices, including diodes used in power supplies, and the resulting spike voltages may damage such semiconductor devices.

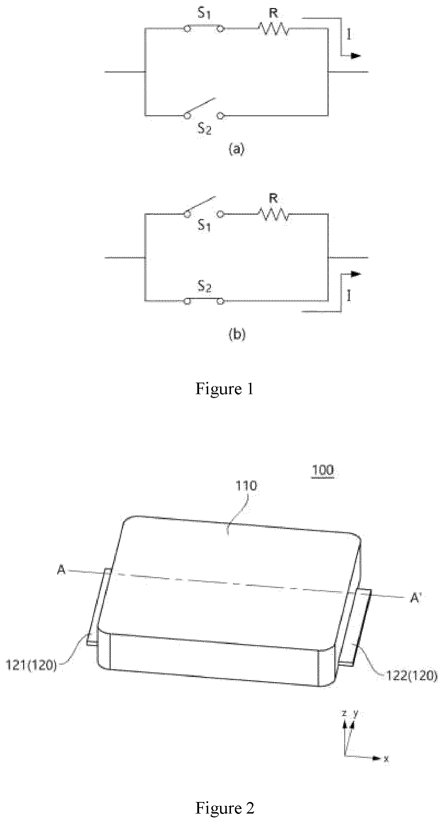

FIG. 1 is a circuit diagram of a circuit protection device according to the related art. Such an conventional circuit protection device includes a resistor R, a first relay S1 connected in series with the resistor R, and a second relay S2 connected in parallel with the resistor R and the first relay S1.

When the circuit protection device is powered on, the first relay S1 closes and the second relay S2 opens, entering state (a). After a predetermined period of time, the first relay S1 opens and the second relay S2 closes, transitioning to state (b).

In state (a) of FIG. 1, the input current flows into the electrical circuit through the first relay S1 and the resistor R. In this case, the resistor R limits the inrush current to a predetermined level, thereby suppressing the inrush current. After a predetermined period of time (e.g., approximately 0.5 seconds) for the input current to stabilize, the circuit protection device switches to state (b), and the normal input current then flows into the electrical circuit through the second relay S2.

Such a conventional circuit protection device comprises a resistor R, a relatively bulky first relay S1, and a second relay S2, leading to high cost, large installation space requirements, and frequent malfunctions. The normal input current may range from 2A to 4A for washing machines and may be 7A or more for dryers. Therefore, high-current relays are required for the first and second relays S1 and S2. However, such high-current relays are expensive and not widely available in South Korea, and most high-current relays are imported from Japan and other countries.

In addition, since the first and second relays S1 and S2 repeatedly open and close each time the electronic device is turned on or off, the durability of the relays decreases over time, resulting in malfunction. Malfunction of the first and second relays S1 and S2 may lead to excessive current flowing into the electrical circuit, or even result in fire. Therefore, circuit protection devices using relays are inherently accompanied by such risk factors.

To address these issues, circuit protection devices using NTC thermistors (negative temperature coefficient thermistors) to reduce inrush current are used. A thermistor is a device that utilizes the property of a semiconductor whose resistance changes in response to temperature variations. Among thermistors, the NTC thermistor exhibits a characteristic in which the resistance decreases as the temperature increases. The NTC thermistor element may include a disc-shaped body, a pair of electrodes formed on surfaces of the body, and a pair of lead wires soldered to and extending from the respective electrodes.

In the related art, such as Korean Patent No. 10-1189853, there has been disclosed a ceramic heat dissipation element that improves heat dissipation characteristics by placing an NTC thermistor element in a ceramic case and filling the case with a cement-based filler.

Such a conventional ceramic heat dissipation element does not present significant issues when applied to home appliances such as 40-inch televisions with power consumption below 200 W, and two to four of the conventional ceramic heat dissipation elements may be connected in series for home appliances with power consumption of around 200 W. For example, when four ceramic heat dissipation elements are connected in series to control a circuit protection device with a total resistance of approximately 5 ohms in a home appliance such as a television, each ceramic heat dissipation element has a resistance of approximately 1.3 ohms. Compared to a single ceramic heat dissipation element having a resistance of 5 ohms, four ceramic heat dissipation elements, each having a resistance of 1.3 ohms, generate less heat (P = I²R, Joule heating), thereby providing improved heat management.

However, when applying existing ceramic heat dissipation elements to home appliances requiring large power consumption exceeding 200 W, such as recently commercialized televisions of 65 inches or larger, heat management requires serial connection of five or more ceramic heat dissipation elements, each having a resistance of less than 1.3 ohms. It is technically difficult to manufacture an NTC thermistor with a resistance of less than 1.3 ohms, and even if such a thermistor is successfully manufactured, the thermistor may fail to exhibit the inherent characteristics of an NTC thermistor.

Accordingly, in the case of home appliances that require large power consumption exceeding 200 W, such as televisions larger than 65 inches, it is impossible to simply connect ceramic heat dissipation elements in series as described above, and in order to handle heat generation due to high current, it is inevitable to use a single ceramic heat dissipation element having a predetermined resistance value (e.g., 5 ohms) as a resistor R in a circuit using a conventional first relay S1 and second relay S2 as illustrated in FIG. 1.

However, if the first relay S1, the second relay S2, and the ceramic heat dissipation element are all used in this way, it is expensive and takes up a lot of space, and the mechanical malfunction and durability problems of the first relay S1 and the second relay S2 described above are also present, so an improved circuit protection device is required.

The recent trend in televisions is that screens are getting bigger and thinner. As display technology advances, the thickness of ultra-slim televisions is also becoming thinner, but the circuit boards included in the television and the circuit components mounted on them may become obstacles in implementing the ultra-slim thickness of slim televisions. In particular, circuit protection devices using a related art have problems in implementing the ultra-thin thickness of wall-mounted televisions due to their thickness.

### SUMMARY

The present disclosure provides a circuit protection device having an SMD structure with a thickness suitable for application to a slim wall-mounted television.

The present disclosure also provides a circuit protection device having a heat dissipation structure effective even in a slim thickness.

The objects of the present disclosure are not limited to the objects mentioned above, and other objects not mentioned will be clearly understood by those skilled in the art from the description below.

In one aspect of the present disclosure, there is provided a circuit protection device including: a plate-shaped thermistor element comprising a first electrode and a second electrode; a first heat-dissipating terminal connected to the first electrode; a second heat-dissipating terminal connected to the second electrode; and a housing for protecting the thermistor element, the first heat-dissipating terminal, and the second heat-dissipating terminal.

In addition, the thermistor element may include a rectangular or circular ceramic plate, and the first and second electrodes printed respectively on opposite surfaces of the ceramic plate.

In addition, the first electrode may be disposed on a top surface of the ceramic plate, and the second electrode may be disposed on a bottom surface of the ceramic plate.

In addition, one end of the first heat-dissipating terminal may be in electrical surface contact with the first electrode, and one end of the second heat-dissipating plate terminal may be in electrical surface contact with the second electrode.

In addition, the other ends of the first and second heat-dissipating plate terminals are in electrical surface contact with the respective terminals on a PCB.

In addition, the first heat-dissipating terminal may be configured such that the other end of the first heat-dissipating terminal is in electrical surface contact with a terminal on the PCB at a same height as the other end of the second heat-dissipating terminal, by means of a first bend and a second bend formed between one end and the other end of the first heat-dissipating terminal.

In addition, the first heat-dissipating terminal and the second heat-dissipating terminal may be configured to dissipate heat generated from the thermistor element to a PCB through conduction.

Specific details of other embodiments are included in the "Detailed Description" and the accompanying drawings.

The advantages and/or features of the present disclosure and the methods for achieving them will become apparent with reference to the various embodiments described in detail below together with the accompanying drawings.

However, the present disclosure is not limited to the configurations of the respective embodiments disclosed below, but may be implemented in various other forms. The embodiments disclosed herein are merely provided to ensure a complete disclosure of the present disclosure and to fully convey the scope of the present disclosure to those skilled in the art. The present disclosure is defined only by the scope of the claims.

### BRIEF DESCRIPTION OF THE DRAWINGS

FIG. 1 is a circuit diagram of a circuit protection device according to a related art.
FIG. 2 is an exemplary view of a circuit protection device according to one embodiment of the present disclosure.
FIG. 3 is an exemplary view showing the top surface of the circuit protection device illustrated in FIG. 2 in a state in which a housing is disassembled.
FIG. 4 is an exemplary view showing the bottom surface of the circuit protection device illustrated in FIG. 2 in a state in which a housing is disassembled.
FIG. 5 is a cross-sectional view of the circuit protection device illustrated in FIG. 2.

### DETAILED DESCRIPTION

Before describing the present disclosure in detail, it should be understood that the terms or expressions used in this specification are not to be interpreted as being limited solely to their conventional or dictionary meanings. The inventor may define such terms appropriately in order to best explain the invention, and these terms should be interpreted as having meanings consistent with the technical spirit of the present disclosure.

The terms used herein are solely for the purpose of describing preferred embodiments of the present disclosure and are not intended to limit its scope. These terms have been defined in consideration of the various possible embodiments of the invention.

Furthermore, unless clearly stated otherwise, the singular forms used herein include the plural forms, and vice versa. Thus, even when expressed in the singular, the meaning may encompass the plural, depending on the context.

Throughout this specification, expressions such as "comprises" or "including" should be interpreted to mean that other elements may also be included, unless explicitly stated otherwise.

Moreover, when a component is described as being "installed in," "connected to," or "located within" another component, this may include both direct and indirect configurations. That is, it may be installed in direct contact with or spaced apart from the other component. In the case of being spaced apart, a third component or means for securing or connecting them may exist, and the description of such third component or means may be omitted unless necessary.

On the other hand, expressions such as "directly connected" or "directly adjacent" indicate that no other component or means exists between the described elements.

Similarly, other relational expressions such as "between" and "directly between," or "adjacent to" and "directly adjacent to" should also be interpreted accordingly.

The terms such as "one surface", "the other surface," "one side," "the other side," "first," and "second," etc., are used for clarity in distinguishing elements and do not limit the nature or order of the components unless expressly stated.

Terms indicating direction or position, such as "upper," "lower," "left," and "right," are used to describe the relative positions shown in the drawings and should be understood as indicating the relative positions of the components in the drawings, and not as defining absolute positions unless explicitly stated.

In this specification, the same reference numerals are used for the same or equivalent components even if they appear in different drawings, so that the same reference numerals consistently indicate the same or equivalent components throughout the specification.

In the drawings attached to this specification, the size, position, connection relationship, etc. of each component constituting the present disclosure may be described in an exaggerated, reduced, or omitted manner in order to sufficiently and clearly convey the idea of the present disclosure or for convenience of explanation, and therefore the proportions or scales may not be strict.

In addition, in the following description of the present disclosure, a detailed description of a configuration that is judged to unnecessarily obscure the gist of the present disclosure, for example, a known technology including the related art, may be omitted.

In the following, embodiments of the present disclosure will be described in detail with reference to the accompanying drawings. For convenience, the X-axis, Y-axis, and Z-axis are defined as the left-right, front-rear, and up-down directions, respectively, in the drawings.

FIG. 2 is an exemplary view of a circuit protection device according to one embodiment of the present disclosure.

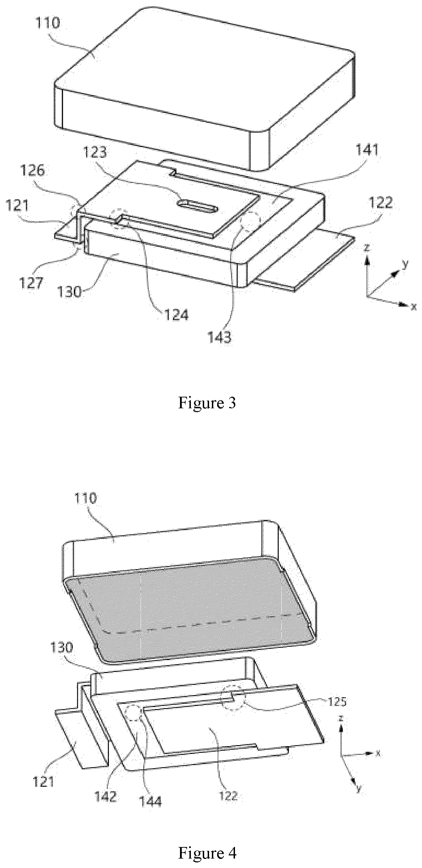

FIG. 3 is an exemplary view showing the top surface of the circuit protection device illustrated in FIG. 2 in a state in which a housing is disassembled.

FIG. 4 is an exemplary view showing the bottom surface of the circuit protection device illustrated in FIG. 2 in a state in which a housing is disassembled.

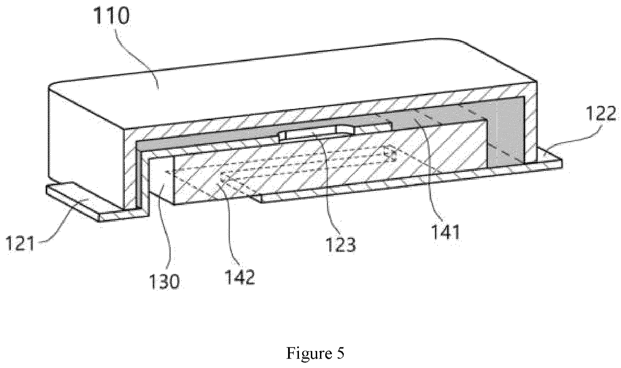

FIG. 5 is a cross-sectional view of the circuit protection device illustrated in FIG. 2. A cross-section cut along line A-A' illustrated in FIG. 2 is shown in FIG. 5.

Referring to FIGS. 2 to 5, a circuit protection device 100 according to one embodiment of the present disclosure may include circuit protection elements and a housing 110. The circuit protection elements include a thermistor element 130, a first heat-dissipating terminal 121, and a second heat-dissipating terminal 122.

The thermistor element 130 is a type of resistor in the form of a semiconductor, whose electrical resistance significantly changes with temperature. The thermistor element 130 may include a negative temperature coefficient (NTC) thermistor or a positive temperature coefficient (PTC) thermistor. The NTC thermistor decreases in resistance as temperature increases. On the other hand, the PTC thermistor increases in resistance as temperature increases.

The thermistor element 130, for example, an NTC thermistor, may be manufactured by forming a square-shaped ceramic plate comprising various transition metal oxides such as Mn and Ni, applying silver (Ag) paste to both surfaces of the square-shaped ceramic plate, and baking the plate to form a first electrode 141 and a second electrode 142, thereby forming a heat-generating body.

The housing 110 may be formed of a plastic having excellent thermal insulation properties. The housing 110 may be formed of a thermosetting plastic such as melamine resin, epoxy resin, or phenol resin. The thermosetting plastic exhibits high hardness and excellent heat resistance, and thus may be used as a material for the housing 110 in embodiments of the present disclosure.

The circuit protection device 100 according to one embodiment of the present disclosure may be mounted on a PCB through SMT (surface mount technology). That is, the circuit protection device 100 corresponds to a SMD (surface mount device) mounted on a surface of the PCB.

The SMT is a type of surface mount technology. DIP-type packages use a method where the component legs(leads) pass through holes in the PCB and are soldered to the opposite side. Unlike the DIP-type packages, SMD-type packages are mounted directly on the surface of the PCB and attached by soldering. Accordingly, the plate-shaped circuit protection device 100 is arranged horizontally on the PCB and directly attached to a terminal on the PCB through heat-dissipating terminals without leads, and may thus be implemented with a height of less than 3 mm.

According to the related art, a thermistor may include a ceramic disc, positive and negative electrodes attached to the ceramic disc, connecting leads respectively connected to the positive and negative electrodes, and a coating that covers the ceramic disc, the positive electrode, and the negative electrode. In the related art, the ceramic disc may be arranged vertically, and the connecting leads may serve as legs to support the ceramic disc and allow mounting into holes of the PCB. In the related art, thermistors dissipate heat through convection or radiation without any special heat dissipating structure.

The thermistor element 130 according to one embodiment of the present disclosure has an ultra-thin structure and includes a special structure for heat dissipation. The circuit protection device 100 may include the first heat-dissipating terminal 121 and the second heat-dissipating terminal 122 that are respectively in electrical contact with the first electrode 141 and the second electrode 142 of the thermistor element 130.

The first and second heat-dissipating terminals 121 and 122 are configured to electrically connect the thermistor element 130 to the PCB and to dissipate heat generated from the thermistor element 130.

The thermistor element 130 may include a rectangular or circular ceramic plate, and the first and second electrodes 141 and 142 printed respectively on opposite surfaces of the ceramic plate. The first electrode 141 and the second electrode 142 may be formed, for example, by printing silver paste (Ag paste) in the form of a thin film on the opposite surfaces of the ceramic plate. Therefore, the first electrode 141 and the second electrode 142 do not increase the thickness of the ceramic plate.

The first electrode 141 may be printed on the top surface of a horizontally arranged ceramic plate, and the second electrode 142 may be printed on the bottom surface of the horizontally arranged ceramic plate. The first electrode 141 may occupy more than 50% of the area of the top surface of the ceramic plate. The second electrode 142 may occupy more than 50% of the area of the bottom surface of the ceramic plate.

The first heat-dissipating terminal 121 and the second heat-dissipating terminal 122 may be formed of aluminum alloy or copper to provide high electrical conductivity and excellent heat dissipation performance. The first heat-dissipating terminal 121 may be in electrical contact with the first electrode 141, and the second heat-dissipating terminal 122 may be in electrical contact with the second electrode 142. For example, the first heat-dissipating terminal 121 may be fixed by soldering while in contact with the first electrode 141. The second heat-dissipating terminal 122 may be fixed by soldering while in contact with the second electrode 142. In this case, the fixing method is not limited to soldering and may also employ, for example, a conductive adhesive.

The first heat-dissipating terminal 121 and the second heat-dissipating terminal 122 may be in contact with a portion of the first electrode 141 or the second electrode 142 for convenience in soldering. For example, the first electrode 141 may have an exposed portion 143, and the second electrode 142 may also have an exposed portion 144. Due to the presence of the exposed portions 143 and 144 of the first and second electrodes 141 and 142, respectively, soldering may be performed without affecting the ceramic plate.

The first heat-dissipating terminal 121 and the second heat-dissipating terminal 122 may include an attachment reinforcement hole 123 and attachment reinforcement parts 124 and 125 to increase bonding strength with the first electrode 141 and the second electrode 142, respectively.

The attachment reinforcement hole 123 may be formed on the first heat-dissipating terminal 121. Soldering may be performed along the perimeter of the attachment reinforcement hole 123 or a conductive adhesive may be applied, thereby increasing the bonding strength between the electrodes and the terminals.

The attachment reinforcement parts 124 and 125 may be formed on the first heat-dissipating terminal 121 and the second heat-dissipating terminal 122, respectively. Each of the attachment reinforcement parts 124 and 125 corresponds to a region where the width in the Y direction of a corresponding one of the first and second heat-dissipating terminals 121 and 122 changes. Likewise, soldering may be performed on the attachment reinforcement portions 124 and 125 or a conductive adhesive may be applied, thereby increasing the bonding strength between the electrodes and the terminals.

Since one end of the first heat-dissipating terminal 121 is in contact with the top surface of the thermistor element 130, the other end must be bent downward by an amount corresponding to the thickness of the thermistor element 130 to come into contact with a terminal on the PCB. Referring to FIG. 3, the first heat-dissipating terminal 121 may be configured such that the other end of the first heat-dissipating terminal 121 is in electrical surface contact with a terminal on the PCB at the same height as the other end of the second heat-dissipating terminal 122, by means of a first bend 126 and a second bend 127 formed between one end and the other end of the first heat-dissipating terminal 121. It is preferable that each of the first bend 126 and the second bend 127 forms a 90-degree angle. However, the present disclosure is not limited thereto, and the sum of the bending angles of the first bend 126 and the second bend 127 may be 180 degrees.

Since the second heat-dissipating terminal 122 is in contact with the bottom surface of the thermistor element 130, the entire bottom surface of the second heat-dissipating terminal 122 may be in contact with a terminal on the PCB.

Based on the mounting surface of the PCB, the height of the circuit protection device 100 according to one embodiment of the present disclosure may be determined by the combined thickness of the housing 110, the ceramic plate, the first heat-dissipating terminal 121 (0.3 mm), and the second heat-dissipating terminal 122 (0.3 mm), and may be implemented within 3 mm.

Referring to FIG. 5, the housing 110 serves to protect the thermistor element 130 of the circuit protection device 100. The housing 110 may be formed by injection molding. The housing 110 may have a predetermined thickness or may be configured to fill the interior of the circuit protection device 100 without any voids, as shown in FIG. 5.

The circuit protection device 100 according to one embodiment of the present disclosure dissipates heat via conduction using: (i) two large-area electrodes formed on opposite surfaces of a rectangular or circular ceramic plate; (ii) two large-area heat-dissipating terminals in contact with the respective electrodes; and (iii) a PCB in contact with the heat-dissipating terminals.

In addition, due to efficient heat dissipation, the circuit protection device 100 is capable of handling high power using a relatively small thermistor element 130.

According to one embodiment of the present disclosure, heat from the circuit protection device 100 may be efficiently dissipated through the heat-dissipating terminals.

In addition, the circuit protection device having an SMD structure may be applied to a slim wall-mounted television.

The effects of the circuit protection device according to the technical concept of the present disclosure are not limited to those described above. Other effects not explicitly mentioned may also be clearly understood by those skilled in the art from the following description.

While several embodiments of the present disclosure have been described above by way of example, the description of various embodiments in the "Detailed Description" is merely illustrative. It will be understood by those skilled in the art that various modifications and equivalent implementations may be made based on the above disclosure without departing from the scope of the present disclosure.

Furthermore, the present disclosure is not limited to the above-described embodiments and may be implemented in various other forms. The foregoing description is provided to fully disclose the present disclosure and to enable those skilled in the art to understand the full scope thereof. The present disclosure is defined only by the claims.

## Claims

1. A circuit protection device comprising:
a plate-shaped thermistor element comprising a first electrode and a second electrode;
a first heat-dissipating terminal connected to the first electrode;
a second heat-dissipating terminal connected to the second electrode; and
a housing for protecting the thermistor element, the first heat-dissipating terminal, and the second heat-dissipating terminal.

2. The circuit protection device of claim 1, wherein the thermistor element comprises:
a rectangular or circular ceramic plate; and
the first and second electrodes printed respectively on opposite surfaces of the ceramic plate.

3. The circuit protection device of claim 2, wherein the first electrode is disposed on a top surface of the ceramic plate, and the second electrode is disposed on a bottom surface of the ceramic plate.

4. The circuit protection device of claim 3, wherein one end of the first heat-dissipating terminal is in electrical surface contact with the first electrode, and one end of the second heat-dissipating plate terminal is in electrical surface contact with the second electrode.

5. The circuit protection device of claim 4, wherein the other ends of the first and second heat-dissipating plate terminals are in electrical surface contact with the respective terminals on a PCB.

6. The circuit protection device of claim 5, wherein the first heat-dissipating terminal is configured such that the other end of the first heat-dissipating terminal is in electrical surface contact with a terminal on the PCB at a same height as the other end of the second heat-dissipating terminal, by means of a first bend and a second bend formed between one end and the other end of the first heat-dissipating terminal.

7. The circuit protection device of claim 1, wherein the first heat-dissipating terminal and the second heat-dissipating terminal are configured to dissipate heat generated from the thermistor element to a PCB through conduction.
